Europäisches Patentamt

European Patent Office

Office européen des brevets

(19)

(11) Numéro de publication: **0 037 301**
**B1**

(12) **FASCICULE DE BREVET EUROPEEN**

(45) Date de publication du fascicule du brevet:
16.05.84

(21) Numéro de dépôt: 81400393.5

(22) Date de dépôt: 13.03.81

(51) Int. Cl.³: **H 01 L 25/16,** H 01 L 23/14,
H 01 L 23/36, H 01 L 23/40,
H 01 L 23/48, H 01 L 25/04

(54) Boîtier d'encapsulation pour module de puissance en circuit hybride.

(30) Priorité: 26.03.80 FR 8006689

(43) Date de publication de la demande:
07.10.81 Bulletin 81/40

(45) Mention de la délivrance du brevet:
16.05.84 Bulletin 84/20

(84) Etats contractants désignés:
BE DE GB IT SE

(56) Documents cités:
FR - A - 1 535 282
FR - A - 2 306 530
FR - A - 2 402 998
GB - A - 1 085 094

IBM TECHNICAL DISCLOSURE BULLETIN, vol. 8, no. 10,
mars 1966 New York, USA A.P. MANDEL et al. "Heat
dissipator assemblies", pages 1460-1461
INSTITUTE OF ELECTRICAL AND ELECTRONICS
ENGINEERS; PROCEEDINGS OF THE 20th
ELECTRONIC COMPONENTS CONFERENCE, 13-15 mai
1970, Washington, USA J.H. HOLLEY "Solder sealing of
large complex hybrid microcircuits" pages 5-11

(73) Titulaire: **THOMSON-CSF, 173, Boulevard Haussmann,
F-75379 Paris Cedex 08 (FR)**
Titulaire: **COMPAGNIE D'INFORMATIQUE MILITAIRE
SPATIALE ET AERONAUTIQUE, 25, rue de Courcelles,
F-75008 Paris (FR)**

(72) Inventeur: **Pribat, Didier, THOMSON-CSF SCPI 173, bld
Haussmann, F-75360 Paris Cedex 08 (FR)**
Inventeur: **Arnould, Guy, THOMSON-CSF SCPI 173, bld
Haussmann, F-75360 Paris Cedex 08 (FR)**

(74) Mandataire: **Wang, Pierre et al, THOMSON-CSF
SCPI 173, Bld Haussmann, F-75379 Paris Cedex 08 (FR)**

Boitier d'encapsulation pour module de puissance en circuit hybride

L'invention concerne un boîtier d'encapsulation pour module de puissance réalisé selon la technologie des circuits hybrides. Elle porte plus particulièrement sur une architecture de montage, qui comprend des moyens nouveaux de connexions de puissance et sur des moyens d'évacuation de la chaleur dégagée par le module ainsi que sur le boîtier lui-même qui est adapté à ces moyens nouveaux.

De même que pour les circuits intégrés, les progrès de la microélectronique hybride sont actuellement limités non pas tant par la complexité ou la miniaturisation, qui sont des problèmes de fabricants de semiconducteurs, que par des problèmes de connexion et d'échauffement en fonctionnement, donc d'évacuation des calories dégagées par les composants des circuits hybrides. C'est ainsi que sur un circuit hybride d'un modèle courant, et non pas de puissance, pour une pastille montée en chip-carrier et répartie sur le substrat céramique, l'évacuation des calories par les seules connexions correspond à un échauffement de 2000°C par Watt, rapporté à une connexion.

Les solutions actuellement employées pour les circuits hybrides dits de puissance, ne donnent pas entière satisfaction du fait que la puissance maximale selon les technologies actuelles est limitée. Soit les circuits hybrides sont réalisés sur un seul substrat, et la puissance maximale est limitée par le fait que l'utilisation de la technologie hybride classique pour les éléments de commande (substrat alumine, intégration de résistances couches épaisses, soudure de composants à 180°C) n'est pas compatible avec le montage à 300°C et plus nécessaire pour les pastilles de puissance. Soit les circuits hybrides sont scindés en une partie de commande sur un substrat, et une partie de puissance dont les composants sont montés chacun en son boîtier de puissance tels que par exemple les boîtiers de diodes de puissance dénommées D04 ou les boîtiers de transistors de puissance dénommés TO3. Mais du fait que le circuit a été scindé en une partie sur un substrat et un ou plusieurs composants de puissance dans leur boîtier propre, il ne s'agit plus à proprement parler, d'un circuit hybride, et on perd beaucoup en intégration.

Le document FR-A-2 306 530 décrit un boîtier d'encapsulation d'un circuit complexe comportant une rondelle de silicium, qui sert de substrat pour des pastilles semiconductrices. Le boîtier comporte un fond de boîtier, constitué par un radiateur, avec interposition d'un répartiteur thermique entre la rondelle de silicium et le radiateur, ainsi qu'un couvercle plat. Ce couvercle est partiellement réalisé en matériau céramique, et il comporte un jeu de broches métalliques qui le traversent et sont ainsi perpendiculaires au substrat. Mais les liaisons électriques entre les composants du circuit et les broches externes se font par un système de pistes conductrices sur le silicium et sur la céramique et de lames métalliques soudées entre elles: ces liaisons électriques ne conviennent pas pour un circuit hybride de puissance et des intensités supérieures à 10 Ampères.

L'architecture du module de puissance selon l'invention, comporte un unique substrat plan sur lequel sont groupés les composants de signal et les composants de puissance qui forment le circuit, et qui est fermé par un couvercle concave en un matériau céramique tel qu'alumine. Les connexions de puissance sont assurées par des broches, supportant une intensité de plusieurs ampères, qui passent à travers le couvercle dans lequel elles sont scellées, cependant que les calories dégagées par les composants de puissance sont évacuées directement par un radiateur sur lequel le substrat est fixé en couplage thermique par l'intermédiaire d'un répartiteur qui a une double fonction thermique et mécanique.

De façon plus précise, l'invention concerne un boîtier d'encapsulation pour module de puissance, en circuit hybride, selon la revendication 1.

L'invention sera mieux comprise et ses avantages ressortiront par la description d'un exemple de réalisation qui va suivre, laquelle s'appuie sur les figures qui représentent

fig. 1 un module de circuit hybride de petite puissance selon l'art connu;

fig. 2 un autre module de circuit hybride de moyenne puissance selon l'art connu;

fig. 3 un boîtier d'encapsulation de module de circuit hybride de moyenne puissance selon l'art connu vu du côté des broches de sortie;

fig. 4 une vue extérieure dans l'espace d'un module de puissance selon l'invention;

fig. 5 une vue en coupe d'une partie du boîtier d'encapsulation selon l'invention montrant un détail de la prise de contact sur un composant;

fig. 6 une autre vue en coupe du boîtier d'encapsulation montrant le scellement des connexions de sortie ainsi qu'un autre mode de prise de contact sur un composant;

fig. 7 vue de face et de profil de l'une des connexions de puissance;

fig. 8 vue en coupe d'un boîtier de puissance fixé sur un radiateur en couplage thermique.

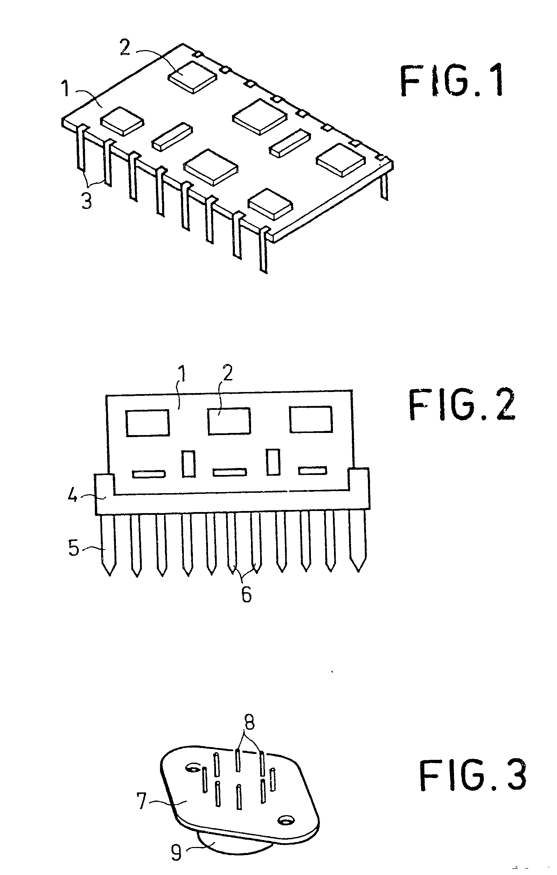

La fig. 1 représente, de façon très schématique, un circuit hybride classique. Sur un substrat 1, plan, généralement constitué par une plaque d'alumine, de céramique, de verre ou de tôle émaillée, sont fixés un certain nombre de composants 2 qui sont des composants actifs, transistors, circuits intégrés, et des composants passifs, diodes, résistances, capacités.

Il s'agit là de composants de signaux et les liaisons avec l'extérieur sont assurées par un certain nombre de connexions de sortie 3. La puissance dissipée est faible, et on peut considérer que les calories dégagées en cours de fonctionnement sont rayonnées dans l'espace environnant plutôt que transmises par les connexions de sortie.

La fig. 2 représente un circuit hybride de moyenne puissance selon l'art connu. Comme le précédent, il comporte un certain nombre de composants actifs et passifs 2 supportés par une plaque de substrat 1, mais les liaisons avec les circuits extérieurs sont assurées au moyen d'un connecteur embrochable. Ce connecteur embrochable comporte, maintenues par une partie rigide isolante 4, une ou deux broches 5 qui servent principalement au guidage, et un nombre adéquat de broches 6 qui servent à la liaison électrique avec le reste du circuit. Par comparaison avec le circuit hybride de petite puissance de la fig. 1, les broches de sortie 6 du circuit hybride moyenne puissance de la fig. 2 sont de taille plus importante et peuvent si nécessaire évacuer un petit nombre de calories. Cependant, la puissance dégagée par ce type de circuit est encore très limitée.

La fig. 3 représente un boîtier d'encapsulation selon l'art connu pour des circuits hybrides de moyenne puissance. Ce boîtier est vu par sa face inférieure. Il comporte un socle 7 constitué d'une plaque métallique épaisse, laquelle sert essentiellement à évacuer les calories dégagées par le circuit hybride. A travers ce socle 7, passent, scellées par des perles de verre, un certain nombre de broches de sortie 8 qui permettent le passage d'une certaine intensité. Cependant, un tel boîtier, qui a les dimensions d'un boîtier d'un transistor de puissance, a l'inconvénient d'être limité en volume et de ne pas admettre de circuit hybride de grande surface; par conséquent, il est de moins en moins utilisé en regard de l'augmentation de la complexité et des dimensions des circuits hybrides actuels. En outre, le boîtier est fermé par un couvercle 9 qui est soudé électriquement sur le socle 7, ce qui empêche toutes interventions ou réglages ultérieurs après la soudure électrique. Un tel boîtier ne peut donc correspondre qu'à une puissance dissipée moyenne, toutes choses étant égales par ailleurs et au regard des puissances que l'on saurait dissiper actuellement si l'on disposait de boîtiers adéquats.

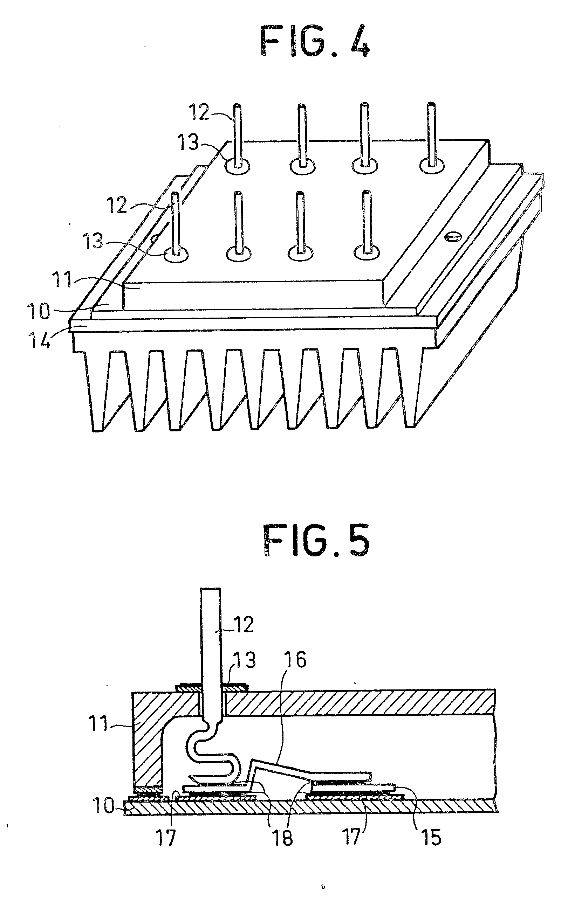

La fig. 4 représente une vue dans l'espace d'un boîtier d'encapsulation pour module de puissance qui résout à la fois le problème des connexions pour forts courants, c'est-àdire plusieurs ampères par connexion, ainsi que le problème de la dissipation de calories correspondant à une forte puissance.

Par forte puissance, il faut entendre une puissance traitée, dépassant plusieurs centaines de Watts, c'est-à-dire, pour prendre des exemples non limitatifs, les puissances mises en œuvre dans des dispositifs tels qu'alimentation à découpage ou onduleur basse tension pour l'alimentation des systèmes électroniques.

Le boîtier représenté par la fig. 4a une forme sensiblement carrée mais cela n'est nullement limitatif car toute autre forme adaptée au dessin du circuit ou à la configuration du système à réaliser, telle qu'une forme qui serait ronde par exemple, entre dans le domaine de l'invention.

Ainsi, ce boîtier selon l'invention, comporte une cavité, scellée et étanche, qui protège les composants du circuit hybride à proprement parler. Ce boîtier est donc constitué par un substrat plan 10, en céramique, mais de façon plus générale en un matériau isolant électrique ayant un bon coefficient de transfert thermique tel que l'oxyde de béryllium, le nitrure de Bore ou le saphyr. Sur ce substrat plan 10 est soudé un couvercle concave 11 dont la profondeur correspond à celle des éléments disposés dans le circuit hybride. Les connexions de sortie sont constituées par des broches 12 dont le diamètre permet de véhiculer des intensités de plusieurs ampères, c'est-à-dire à titre d'exemple une dizaine d'ampères. Ces broches métalliques 12 passent à travers le couvercle du boîtier et sont maintenues par des métallisations 13 qui assurent leur soudure. Le substrat 10 est en outre réuni en couplage thermique avec un socle métallique (14) (Cu, Al ...) pour faciliter la fixation du microcomposant sur un élément radiateur qui est ici représenté sous la forme d'un élément de radiateur à ailettes en aluminium coulé, mais qui peut également être constitué par une partie du châssis du système électronique plus complexe, lequel dissipe la chaleur.

Le boîtier ainsi décrit sommairement sur cette figure, et qui sera expliqué plus en détail à l'occasion des figures suivantes, apporte une solution à un certain nombre de problèmes. L'un des problèmes actuels des boîtiers de puissance, est celui de couvercle 11, également appelé capot. Les circuits hybrides dissipant des puissances de l'ordre de plusieurs dizaines de watts, sont actuellement relativement peu répandus en raison même des problèmes qui ont été évoqués précédemment. Leur emploi est développé essentiellement dans des matériels militaires ou spatiaux ou encore professionnels, c'est dire que le nombre de tels boîtiers fabriqués est relativement petit par rapport aux séries des matériels grand public, et que, bien souvent, de tels circuits hybrides de puissance sont réalisés à la demande. Par conséquent, la réalisation de capots tels qu'on les fait en métal est assez coûteuse, pour les petites séries. En outre, s'il fallait faire passer des broches de sortier 12 du boîtier selon l'invention à travers le capot métallique, on se heurterait à deux difficultés: soit le capot est réalisé dans une tôle relativement fine donc facile à emboutir mais alors la fixation des broches 12 à travers des perles de verre 13 isolantes poserait des problèmes de fiabilité car les perles de verre cassent facilement; soit le capot est réalisé en un matériau métallique assez épais pour que les passages verre-métal 13 soient solides mais alors le capot ne peut plus être embouti, il doit être usiné, ce qui élève son prix et limite la fabrication. Un autre mode de fabrication des capots est de les mouler en complexe résine époxy et tissu de verre assurant l'étanchéité autour des connexions de sortie 12 mais cette technologie n'est pas acceptée par certains matériels professionnels tels que les matériels militaires ou spatiaux.

La solution retenue au titre de l'invention est à la fois économique, admise par les normes militaires ou spatiales, et de mise en œuvre dacile: il s'agit de réaliser des couvercles 11 ou capots en matériau céramique tel qu'alumine qui sont facilement mis en œuvre pour de petites séries, sont isolants électriquement et d'une épaisseur suffisante pour que le scellement en 13 des broches de sortie 12 soit efficace et peu fragile.

Par ailleurs, il ressort aisément du fait que les broches de sortie 12 passent à travers un couvercle plan qu'elles sont parallèles entre elles, ce qui fait que le circuit hybride porté par le boîtier de puissance selon l'invention, peut être raccordé directement ou être embrochable sur un connecteur adéquat.

Enfin, et ceci ressortira de la description supportée par les figures suivantes, le fait que les éléments de puissance contenus à l'intérieur du boîtier d'encapsulation ont des liaisons très courtes en direction des broches de sortie 12 d'une part, et en direction du radiateur 14 d'autre part, permet de réduire l'échauffement par perte locale et améliore la fiabilité.

La fig. 5 représente une coupe partielle d'un boîtier de puissance selon l'invention.

Sur le substrat plan 10 est soudé un couvercle 11 à travers lequel passe par un orifice une broche de sortie 12 qui est soudée en 13. Les détails relatifs au soudage de la broche 12 seront exposés ultérieurement. La broche 12 est réunie électriquement à la pastille du composant de puissance 15, diode ou transistor par exemple, par l'intermédiaire d'une languette conductrice 16.

La chaîne électrique et thermique, depuis la broche 12 jusqu'au répartiteur 14, non représenté sur cette figure, qui est en couplage thermique avec le substrat 10, est composée d'une partie relative aux composants de puissance 15, et d'une partie relative à la broche de sortie 12. D'un côté, le composant de puissance 15 est soudé sur le substrat 10 au moyen d'une métallisation en couche épaisse 17 déposée sur le substrat et d'une préforme 18 qui assure la soudure entre composant et métallisation épaisse. Le composant actif 15 est par ailleurs réuni à la broche de sortie 12 par l'intermédiaire d'une patte métallique et conductrice 16 sur laquelle il est soudé au moyen d'une seconde préforme de soudure 18. D'un autre côté, la broche de sortie 12 est soudée dans sa partie inférieure sur le substrat 10 au moyen d'une seconde métallisation épaisse 17, mais la patte conductrice métallique 16 étant prise en sandwich entre la métallisation épaisse 17 et la partie inférieure de la broche 12, entre deux autres préformes de soudure 18. Ainsi, la broche 12 est rendue solidaire du substrat 10 d'une part, le composant de puissance 15 est également rendu solidaire du substrat 10 d'autre part, et une patte métallique 16 assure la connexion entre les deux. La patte métallique est constituée non pas d'un fil comme c'est généralement le cas pour les semiconducteurs, mais d'une bande métallique dont la section autorise le passage de plusieurs ampères.

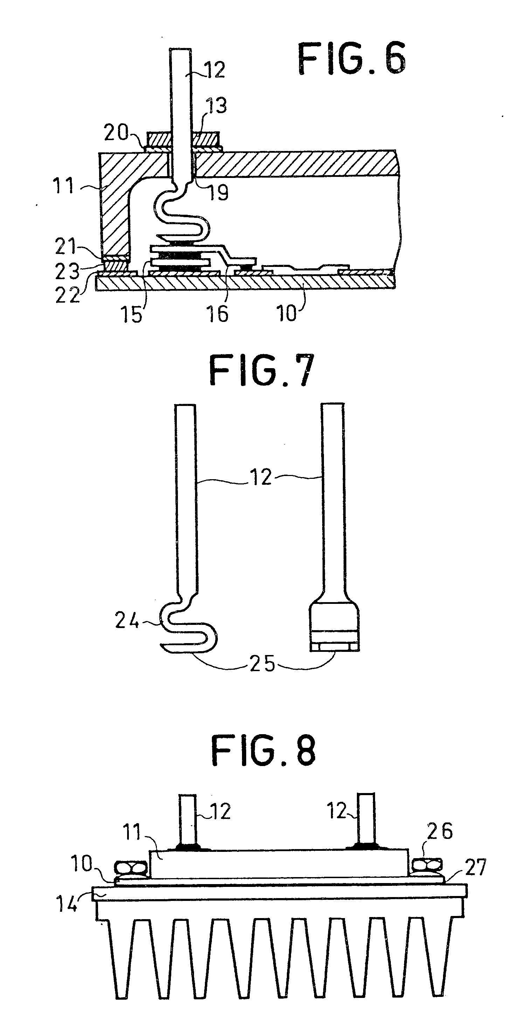

La fig. 6 représente une vue en coupe d'une partie du boîtier selon l'invention, cette vue en coupe permettant de mettre en évidence trois détails dans les soudures.

Comme sur la fig. 5, le boîtier est composé par un substrat 10 et un couvercle 11. A l'intérieur du boîtier, sont fixés divers composants formant un circuit hybride dans les détails duquel on n'entrera pas.

La broche de sortie 12 qui passe à travers le couvercle 11 du boîtier, à travers un trou 19 est fixé par soudure. Cette soudure est réalisée lorsque le circuit hybride dans son boîtier de puissance est terminé, par fusion d'une préforme de soudure 13 sur une plage métallisée 20, laquelle plage de soudure avait été faite préalablement sur le couvercle. Les dimensions et la précision d'usinage sont suffisantes et permettent à la plage métallisée 20 d'être suffisament proche de la broche 12, pour que la préforme de soudure 13, en fondant, mouille la broche 12 sans couler à travers le trou 19.

Par ailleurs, le boîtier est fermé par une soudure étain-plomb sous atmosphère d'azote hydrogéné ce qui le rend hermétique et répond aux normes les plus sévères des matériels militaires ou spatiaux. Le capot 11 est métallisé sur sa partie 21 qui entre en contact avec le substrat 10 lorsque ces deux pièces sont rapprochées, le substrat 10 étant lui-même métallisé sur sa partie 22 correspondante. La fermeture du boîtier se fait au moyen d'une préforme 23 de soudure tendre par refusion en four à hydrogène en atmosphère d'azote hydrogéné. Cette fermeture qui se fait simultanément à la soudure des connexions de sortie 12 au moyen des préformes 13 assure l'étanchéité du boîtier au niveau du joint entre ces deux pièces principales et au niveau des connexions de sortie.

Le procédé de fermeture en four sous atmosphère légèrement réductrice, assure simultanément que le circuit hybride est enfermé de façon étanche dans un boîtier qui est lui-même rempli par une atmosphère neutre d'azote et d'hydrogène.

La fig. 6 montre également un autre procédé de connexion interne au boîtier selon l'invention. Alors que sur la fig. 5, la broche 12 était soudée sur le substrat 10, à côté du composant 15 auquel elle était reliée par une patte métallique 16 capable de supporter un courant élevé, le composant 15, est, sur la fig. 6, soudé entre le substrat 10 et la broche 12. Une telle structure en sandwich permet de diminuer les résistances de contacts et d'augmenter le courant véhiculé, d'autant plus qu'elle correspond au plus court chemin entre une broche de connexion extérieure 12 et le substrat 10, à travers lequel est évacuée la chaleur. Ce type de montage est complété par une patte métallique 16, prise en sandwich entre la broche 12 et le composant 15, et qui établit le contact avec le reste du circuit hybride.

La fig. 7 représente une vue de face et de profil, de l'une des connexions de sortie du boîtier selon d'invention.

Une telle broche de sortie, réalisée en cuivre ou en un matériau conducteur, comporte une partie linéaire 12 d'un diamètre de l'ordre de 1 mm, c'est-à-dire nettement plus important que les connexions réalisées en sortie des circuits hybrides standards. Cette partie linéaire 12 est prolongée, du côté de la connexion qui se trouve à l'intérieur du boîtier selon l'invention, par une partie dont le métal a d'abord été aplati comme il est montré sur la vue de face, puis ensuite recourbé une ou plusieurs fois, comme il est montré en 24 sur la vue de profil, de façon à donner à cette pièce métallique une certaine souplesse pour qu'elle exerce une pression sur la métallisation ou sur le composant contre lequel elle est soudée. L'extrémité de la partie souple 24 de cette connexion comporte un replat 25 dont les bords sont chanfreinés, ce replat étant la partie de la broche de connexion qui est soudée sur les composants et son chanfrein étant destiné à ne pas blesser les couches superficielles des composants actifs.

La fig. 8 représente une vue en élévation d'un boîtier selon l'invention fixé sur un radiateur.

L'ensemble du boîtier est fixé par son substrat 10 sur un répartiteur thermique 14 qui est lui-même monté sur un radiateur représenté ici sous forme d'un radiateur à ailettes. Cependant, comme il a été dit, la forme de ce radiateur n'est pas limitative de l'invention, l'important étant que le radiateur ait suffisament de surface et de masse calorifique pour absorber les calories dégagées à travers le substrat d'oxyde de bérylium 14 et les dissiper. Ce radiateur peut donc être une partie telle que le châssis ou la caisse renfermant un dispositif électronique beaucoup plus complexe que le seul boîtier de circuit hybride décrit.

Plusieurs façons de fixer le boîtier selon l'invention sur le répartiteur peuvent être utilisées séparément ou conjointement. En premier lieu, le boîtier peut être fixé par deux écrous 26 munis de rondelles élastiques afin de ne pas casser le substrat au cours du serrage. Un second mode de fixation est constitué par une couche de colle 27 placée entre le substrat et le radiateur: dans ce cas, il faut prévoir que la colle ne constitue pas un écran thermique. C'est pourquoi, il est dans certains cas préférable de remplacer la couche de colle 27 par une couche de graisse de silicone par exemple, laquelle transmet assez bien la chaleur, et de réunir le boîtier et le radiateur par l'intermédiaire d'un certain nombre de clips qui les enserrent tous les deux sur leur pourtour.

Le dispositif électronique tel que par exemple l'alimentation à découpage ou onduleur basse tension, ainsi encapsulé dans un boîtier de puissance selon l'invention, constitue ce que l'on appelle un macro-composant en ce sens qu'il forme un tout qui reçoit une certaine tension d'alimentation, délivre un courant ou une tension répondant à des spécifications précises et qu'il est autonome en ce qui concerne la puissance dissipée.

D'autres caractéristiques et avantages du boîtier d'encapsulation pour module de puissance selon l'invention ressortiront pour l'homme de l'art des revendications ci-après.

## Revendications

1. Boîtier d'encapsulation pour circuit hybride de puissance, comportant:

— un substrat (10), plan, faisant fonction de fond de boîtier, et sur la face supérieure duquel sont fixés les composants (15) du circuit hybride et sont prévues les connexions intérieures du circuit hybride,
— un couvercle (11), constitué d'un matériau céramique, isolant électrique, situé au dessus du substrat (10) et fixé sur celui-ci,
— les connexions extérieures du circuit, constituées par des broches (12), orientées perpendiculairement au substrat (10) et passant par des trous (19) à travers la partie du couvercle (11) parallèle au substrat (10),
— un répartiteur (14), fixé en couplage thermique sous le substrat (10), et assurant les fonctions d'interface thermique et mécanique avec un échangeur thermique,

ce boîtier étant caractérisé en ce que les connexions extérieures sont constituées par des broches métalliques de dimensions aptes à supporter le passage d'un courant pouvant dépasser 10 ampères, dont une extrémité rectiligne (12) passe à travers le couvercle (11) sur lequel elle est soudée, et dont l'autre extrémité (25) est soudée sur le circuit hybride.

2. Boîtier d'encapsulation selon la revendication 1, caractérisé en que l'extrémité des broches internes au boîtier est aplatie (24) puis recourbée afin de lui communiquer de la souplesse pour absorber les dilatations, et comporte un plat (25), chanfreiné, soudé sur le circuit hybride.

3. Boîtier d'encapsulation selon la revendication 1, caractérisé en ce que la liaison entre une connexion extérieure (12) au boîtier et un composant (15) du circuit est directe, la broche de connexion étant soudée directement sur le composant (15), par le plat (25) de son extrémité interne au boîtier.

4. Boîtier d'encapsulation selon la revendication 1, caractérisé en ce que les connexions intérieures sont constituées par des pattes métalliques (16) soudées d'une part sur un composant (15) du circuit hybride et d'autre part sur une broche de connexion extérieure (12), lesdites pattes métalliques (16) étant prises en sandwich entre cette broche (12) et le substrat (10).

## Patentansprüche

1. Einkapselgehäuse für einen Hybrid-Kraft-Stromkreis, umfassend:

- eine den Gehäuseboden bildende ebene Trägerschicht (10), an deren oberer Oberfläche die Bauteile (15) des Hybridstromkreises befestigt und die Innenanschlüsse des Hybridstromkreises vorgesehen sind;
- einen aus elektrisch isolierendem Keramikmaterial gefertigten, oberhalb der Trägerschicht (10) angeordneten und an derselben befestigten Deckel (11);
- die durch senkrecht zur Trägerschicht (10) angeordneten, sich durch Löcher (19) des zur Trägerschicht (10) parallelen Teils des Deckels (11) erstreckende Stifte (12) gebildeten Außenanschlüsse des Stromkreises;
- einen mit wärmeleitendem Kontakt unter der Trägerschicht (10) befestigten, als thermische und mechanische Grenzfläche mit einem Wärmeaustauscher wirkenden Verteiler (14);

dadurch gekennzeichnet, daß die Außenanschlüsse durch metallische Stifte gebildet werden, die derart bemessen sind, daß sie den Durchgang eines Stroms von mehr als 10 Ampere ertragen, wobei ein geradliniges Ende (12) der Stifte den Deckel (11) durchquert, an welchem es angeschweißt ist, während das andere Stiftende (25) an dem Hybridstromkreis angeschweißt ist.

2. Einkapselgehäuse nach Anspruch 1, dadurch gekennzeichnet, daß das im Innern des Gehäuses befindliche Ende der Stifte abgeflacht (24) und sodann gebogen ist, um eine das Aufnehmen der Ausdehnungen gestattende Nachgiebigkeit zu besitzen und dieses Stiftende ferner einem am Hybridstromkreis angeschweißten, abgeschrägten Flachteil (25) besitzt.

3. Einkapselgehäuse nach Anspruch 1, dadurch gekennzeichnet, daß die Verbindung zwischen einem außerhalb des Gehäuses befindlichen Anschluß (12) und einem Bauteil (15) des Stromkreises direkt ist, indem der Anschluß-Stift mit dem Flachteil (25) seines im Gehäuseinnern befindlichen Endes direkt an den Bauteil (15) angeschweißt ist.

4. Einkapselgehäuse nach Anspruch 1, dadurch gekennzeichnet, daß die Innenanschlüsse durch einerseits an einen Bauteil (15) des Hybridstromkreises und andererseits an einen Außenanschluß-Stift (12) angeschweißte, zwischen diesem Stift (12) und der Trägerschicht (10) angeordnete metallische Lappen (16) gebildet sind.

## Claims

1. Encapsulation housing for a hybrid power circuit, comprising:

- a plane substrate (10), having the function of a housing bottom, and on the upper face of which are fixed the components (15) of the hybrid circuit and are provided the internal connections of the hybrid circuit;
- a cover (11), constituted from an electrically insulating ceramic material, situated above the substrate (10) and fixed on it;
- external connections of the circuit, constituted by pins (12) oriented perpendicular to the substrate (10) and passing through holes (19) formed in the part of the cover (11) parallel to the substrate (10);
- a dispatcher (14), fixed in thermal coupling under the substrate (10), and ensuring the function of the thermal and mechanical interface with a thermal exchanger,

this housing being characterized in that the external connections are constituted by metallic pins of dimensions adapted to support the passage of a current beyond 10 amperes, of which one rectilinear end (12) passes through the cover (11) on which it is welded, and of which the other end (25) is welded on the hybrid circuit.

2. An encapsulation housing according to claim 1, characterized in that to obtain the flexibility required to absorb dilatation the end of the pins external to the housing is flattened (24) then curved and comprises a flat part (25), chamfered and welded on the hybrid circuit.

3. An encapsulation housing according to claim 1, characterized in that the link between a connection (12) external to the housing and a component (15) of the circuit is direct, the connection pin being welded directly on the component (15), by the flat part (25) of its end internal to the housing.

4. An encapsulation housing according to claim 1, characterized in that the internal connections are constituted by metallic lugs (16) welded, on the one hand on an component (15) of the hybrid circuit and on the other hand, on an external connection pin (12), the said metallic lugs (16) being sandwiched between the pin (12) and the substrate (10).

FIG.1

FIG.2

FIG.3

# FIG. 4

# FIG. 5

# FIG. 6

12

13

20

11

19

21

23

22

15   16   10

# FIG. 7

12

24

25

# FIG. 8

12      12

11            26

10                27

14